(19) Europäisches Patentamt / European Patent Office / Office européen des brevets

(11) **EP 1 318 606 B1**

(12) **EUROPÄISCHE PATENTSCHRIFT**

(45) Veröffentlichungstag und Bekanntmachung des Hinweises auf die Patenterteilung:
**13.10.2010  Patentblatt 2010/41**

(51) Int Cl.:
**H03K 17/94** *(2006.01)*

(21) Anmeldenummer: **01811175.7**

(22) Anmeldetag: **04.12.2001**

(54) **Fotoelektrischer Näherungsschalter**

Photoelectric proximity switch

Commutateur de proximité photoélectrique

(84) Benannte Vertragsstaaten:
**CH DE FR GB IT LI**

(43) Veröffentlichungstag der Anmeldung:
**11.06.2003  Patentblatt 2003/24**

(73) Patentinhaber: **Optosys SA**
**1762 Givisiez (CH)**

(72) Erfinder: **Heimlicher, Peter**
**1700 Freiburg (CH)**

(74) Vertreter: **AMMANN PATENTANWÄLTE AG BERN**
**Schwarztorstrasse 31**
**3001 Bern (CH)**

(56) Entgegenhaltungen:
**DE-A- 19 926 214    US-A- 5 243 182**
**US-A- 5 250 801**

**Beschreibung**

Die Erfindung betrifft einen fotoelektrischen Näherungsschalter zur Feststellung von einem in einem Überwachungsbereich vorhandenen Gegenstand gemäss Oberbegriff des Anspruchs 1.

Die Erfindung betrifft ferner ein System zur Feststellung von in einem Überwachungsbereich vorhandenen Gegenständen.

Die Erfindung betrifft ausserdem ein Verfahren zur Feststellung von einem in einem Überwachungsbereich vorhandenen Gegenstand mittels eines fotoelektrischer Näherungsschalters der oben erwähnten Art.

Die Verwendung von Licht als Übertragungsmedium von Informationen ist weit verbreitet. Licht hat gegenüber anderen Medien viele Vorteile, wie Unabhängigkeit gegenüber äusseren magnetischen und elektrischen Feldern, grosse Fortpflanzungsgeschwindigkeit, grosse Reichweiten, Formgebung des Strahlenbündels durch einfache optische Anordnungen etc. Im weiteren stehen heute sehr leistungsfähige elektronische Bauteile zur Erzeugung und zur Detektion von Licht zur Verfügung. Diese zeichnen sich zudem durch praktisch unbegrenzte Lebensdauer, grosse Bandbreite und Wirtschaftlichkeit aus.

Das Hauptproblem bei der Verwendung von Licht zur SignalÜbertragung besteht vielfach darin, dass beim Einsatz von mehr als einem Sender-Empfänger-Paar im gleichen Raum jeder Empfänger Licht von verschiedenen Sender empfangen kann, und die Empfangseinrichtung nicht feststellen kann, von welchem Sender das empfangene Licht stammt.

Die Lichtübertragung von einem Sender zu einem Empfänger kann dabei direkt oder durch eine Reflexion oder durch mehrfache Reflexionen erfolgen. Dieses Problem kann dadurch gelöst werden, dass jeder Sender seinem Licht eine zusätzliche Information mitgibt, die von den Empfängern ausgewertet werden und zur Identifikation benützt werden kann. Hierzu sind viele Möglichkeiten bekannt, z. B. indem dem von jedem Sender gesendetes Licht eine bestimmte Wellenlänge und/oder Polarisation zugeordnet wird, oder durch Benutzung verschiedener Arten von Modulation bzw. Codierung sowie Kombinationen davon. Modulation des ausgesendeten Lichtes ist technisch besonders interessant, hat aber den Nachteil, dass sie in jedem Fall die an sich verfügbare Bandbreite reduziert.

Das oben erwähnte Problem tritt z.B. bei photoelektrischen Näherungsschaltern ganz ausgeprägt in Erscheinung. Diese werden vorwiegend im Fertigungs-, Förder- und Lagerbereich eingesetzt. Zunehmende Anforderungen an die Anlagen führen zum Einsatz einer immer grösseren Anzahl von Sensoren auf beschränktem Raum. Die Wahrscheinlichkeit unerwünschter gegenseitiger Beeinflussung zwischen verschiedenen Sender-Empfänger-Paare nimmt damit zu. Es ist daher wünschenswert, dem Anwender Sender-Empfänger-Paare zur Verfügung zu stellen, die er ohne spezielle Vorkehrungen nach Belieben einsetzen kann. Nicht gewünscht werden insbesondere Sender-Empfänger-Paare, die vor deren Inbetriebnahme durch vorgängige Massnahmen individuell identifizierbar gemacht werden müssen, denn dadurch werden insbesondere der Logistikaufwand und das Fehlerrisiko beim Einbau von Ersatzteilen erhöht.

Auch eine signalmässige Verbindung zwischen den verschiedenen Sender-Empfänger-Paaren kommt wegen des zusätzlichen Verdrahtungsaufwandes in der Regel nicht in Frage.

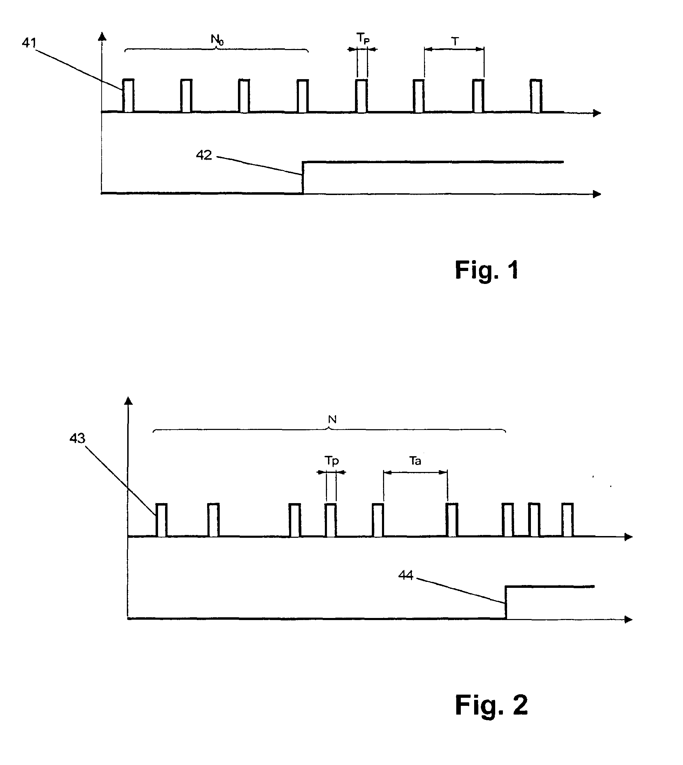

Zur Verbesserung des Signal-Rauschverhältnisses und zur Verringerung der Umgebungslichtempfindlichkeit verwenden photoelektrische Näherungsschalter gemäss Stand der Technik überwiegend pulsmodulierte Sende-Lichtimpulse 41 wie diejenigen, die in der Fig. 1 gezeigt werden.

Zur Verbesserung der Schaltsicherheit bzw. Schaltzuverlässigkeit ist zudem die Empfangseinrichtung so eingerichtet, dass jeweils eine Anzahl No empfangene Impulse abgewartet wird, bevor ein Zustandswechsel des Ausgangssignals 42 der Empfangseinrichtung ausgelöst wird. Ein solches Zustandswechsel signalisiert die Anwesenheit eines festzustellenden Gegenstandes im Überwachungsbereich. Dadurch wird grundsätzlich auch das Risiko der gegenseitigen Beeinflussung zwischen benachbarten Sender-Empfänger-Paaren reduziert. Da allerdings die Pulsfrequenz aller Exemplare einer bestimmten Gerätebaureihe annähernd, aber bedingt durch Bauteilestreuung nicht genau gleich ist, kommt es von Zeit zu Zeit zu gleicher Phasenlage der Impulsfolgen und damit trotzdem zur unerwünschten gegenseitigen Beeinflussung.

Aus der Patentschrift DE 40 31 142 C 2 ist ein Verfahren bekannt, gemäss dem jedes Sender-Empfänger-Paar vor Aussendung eines Lichtimpulses prüft, ob zu diesem Zeitpunkt bereits Licht von einem benachbarten Sender-Empfänger-Paar auf seinen Empfänger fällt. Ist dies der Fall, so wird die Aussendung des Sende-Lichtimpulses so lange verzögert, bis der Lichtempfänger kein Fremdlicht mehr empfängt, und erst dann wird ein Lichtimpuls ausgesendet. Dieses bekannte Verfahren hat aber mehrere Nachteile. Da die Verzögerung der Sende-Lichtimpulse nicht zu lang werden darf, ist die damit erzielte Funktionsweise insbesondere dann unbefriedigend, wenn gleichzeitig mehr als zwei Geräte zum Einsatz kommen. Die Funktionsweise des aus der Patentschrift DE 40 31 142 C 2 bekannten Verfahrens ist ausserdem dann unzuverlässig, wenn Sende-Lichtimpulse durch zwei oder mehrere Geräte genau gleichzeitig ausgesendet werden, was infolge deren unsynchronisierten Betriebes zwangsläufig von Zeit zu Zeit vorkommt.

Andere bekannten Verfahren arbeiten mit aufwendigen Modulationen bzw. Codierungen. Aus der deutschen Patentanmeldung DE 199 26 214 A1 ist z.B. ein Verfahren bekannt, bei dem Modulation sogar in Verbindung mit einer Korrelationsanalyse eingesetzt wird. Auch dieses bekannte Verfahren hat erhebliche Nachteile. Nachteilig ist vor allem der Zeitaufwand für die Berechnung der Korrelation, aber auch die Unzuverlässigkeit des damit erzielten Ergebnisses. Je nach dem, wie der Schwellenwert der Korrelationsfunktion festgelegt wird, ist die Wahrscheinlichkeit von Fehlimpulsen nämlich höher oder tiefer, bei umgekehrt proportionalem Zeitbedarf.

Aus der Patentschrift US 5,243,182 ist ein Verfahren bekannt, bei welchem die Impulssequenz der vom Impulslichtsender abgegebenen Sende-Lichtimpulse zufallsmoduliert ist. Ein Feststellungssignal, welches die Anwesenheit eines festzustellenden Gegenstand angibt, wird dann erzeugt, wenn der Lichtempfänger aus einer Folge von N Sende-Lichtimpulsen N Lichtimpulse empfängt, die alle die gleiche zeitliche Lage wie ein korrespondierender Sende-Lichtimpuls haben. Nachteilig an diesem Verfahren ist, dass es nicht robust ist, beispielsweise gegenüber elektrische Störungen oder Rauschen in der Eingangsstufe. Derartige Einflüsse können dazu führen, dass der Lichtempfänger nicht alle Sende-Lichtimpulse aus einer Folge empfängt und somit die Anwesenheit des Gegenstandes nicht zuverlässig feststellbar ist.

Der Erfindung liegt daher die erste Aufgabe zugrunde, einen fotoelektrischen Näherungsschalter der eingangs erwähnten Art zur Verfügung zu stellen, welcher eine zuverlässige Feststellung der Anwesenheit eines in einem Überwachungsbereich vorhandenen Gegenstand auch dann ermöglicht, wenn eine Vielzahl solcher fotoelektrischen Näherungsschalter gleichzeitig in einem Raum verwendet werden, in dem jeder Lichtempfänger Licht aus mehr als einem Lichtsender und auch Störlicht empfangen kann.

Die soeben definierte erste Aufgabe soll vorzugsweise so gelöst werden, dass eine zuverlässige Feststellung der Anwesenheit eines in einem Überwachungsbereich vorhandenen Gegenstand möglich ist,

- ohne Massnahmen zur individuellen Identifikation der fotoelektrischen Näherungsschalter,
- ohne die übrigen Leistungen der fotoelektrischen Näherungsschalter, insbesondere deren Schaltfrequenz und Stromaufnahme, zu beeinträchtigen, und
- ohne nennenswerte Mehrkosten zu verursachen.

Der Erfindung liegt ferner die zweite Aufgabe zugrunde ein System zur Feststellung von in einem Überwachungsbereich vorhandenen Gegenständen zur Verfügung zu stellen, mit dem die oben erwähnten Nachteile behoben werden.

Der Erfindung liegt ferner die dritte Aufgabe zugrunde ein Verfahren zur Feststellung von einem in einem Überwachungsbereich vorhandenen Gegenstand mittels eines fotoelektrischer Näherungsschalters der oben erwähnten Art zur Verfügung zu stellen, mit dem die oben erwähnten Nachteile behoben werden.

Die mit der Erfindung erzielten Vorteile liegen insbesondere darin, dass damit die oben erwähnten Aufgaben auf vorteilhafter Weise gelöst werden, und dass sie einen zuverlässigen Betrieb von einer Vielzahl fotoelektrischer Näherungsschalter ermöglicht, die auf engen Raum angeordnet sind, auch bei vorhandenem Störlicht ermöglicht.

Erfindungsgemäss wird die oben erwähnte erste Aufgabe mit einem fotoelektrischen Näherungsschalter gemäss Anspruch 1 gelöst.

Erfindungsgemäss wird die oben erwähnte zweite Aufgabe mit einem System gemäss Anspruch 9 gelöst.

Erfindungsgemäss wird die oben erwähnte dritte Aufgabe mit einem Verfahren gemäss Anspruch 10 gelöst.

Bevorzugte Ausführungsformen der Erfindung sind durch Unteransprüche definiert.

Im Folgenden werden anhand der beiliegenden Zeichnungen einige Ausführungsbeispiele der Erfindung beschrieben. Es stellen dar

Fig. 1 ein Diagramm des zeitlichen Verlaufs von Sende- Lichtimpulsen 41 und des Ausgangssignals 42 der Empfangssignalauswerteeinrichtung eines im Stand der Technik bekannten fotoelektrischen Näherungsschalters,

Fig. 2 ein Diagramm des zeitlichen Verlaufs von Sende- Lichtimpulsen 43 und des Ausgangssignals 44 der Empfangssignalauswerteeinrichtung eines erfindungsgemässen fotoelektrischen Näherungsschalters,

Fig.3 das Blockschaltbild eines erfindungsgemässen fotoelektrischen Näherungsschalters,

Fig. 4 ein erstes Ausführungsbeispiel des Zufallssignalsgenerators 14 in Fig. 1,

Fig. 5 ein zweites Ausführungsbeispiel des Zufallssignalsgenerators 14 in Fig. 1,

Fig. 6 eine schematische Darstellung eines Systems, das eine Vielzahl von erfindungsgemässen, fotoelektrischen Näherungsschaltern umfasst.

AUSFÜHRUNGSBEISPIELE EINES ERFINDUNGSGEMÄSSEN FOTOELEKTRISCHEN NÄHERUNGSSCHALTERS

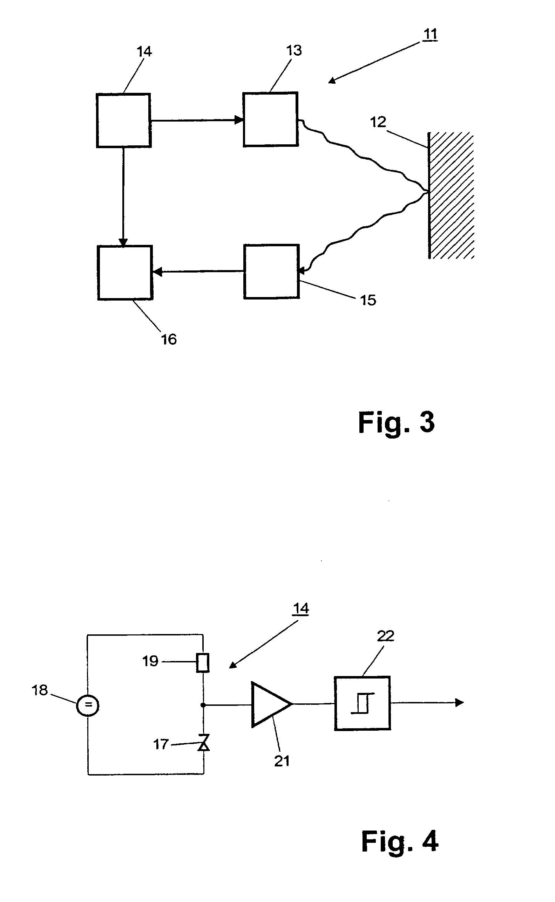

Wie aus Fig. 3 ersichtlich, enthält ein erfindungsgemässer fotoelektrischer Näherungsschalter 11 zur Feststellung von einem in einem Überwachungsbereich vorhandenen Gegenstand 12 folgende Komponenten bzw. Funktionsblöcke: einen Impulslichtsender 13, einen Impulsgeber 14, einen Lichtempfänger 15 und eine Empfangssignalauswerteeinrichtung 16. Der Impulsgeber 14 ist vorzugsweise ein Zufallssignalgenerator.

Der Impulslichtsender 13 sendet von einem Ausgangssignal des Impulsgebers 14 ausgelöste, voneinander je einen zeitlichen Abstand aufweisende Sende-Lichtimpulse in den Überwachungsbereich aus.

Der Lichtempfänger 15 ist relativ zum Impulslichtsender 13 und zum Überwachungsbereich so angeordnet, dass er bei Abwesenheit von einem festzustellendem Gegenstand 12 im Überwachungsbereich im Wesentlichen kein Licht vom Impulslichtsender 13 empfängt, jedoch bei Anwesenheit eines festzustellenden Gegenstandes im Überwachungsbereich durch Reflexion so viel Licht vom Impulslichtsender 13 erhält, dass eine an den Lichtempfänger 15 angeschlossene Empfangssignalauswerteeinrichtung 16 ein Gegenstands-Feststellungssignal abgibt.

Ein erster Ausgang des Zufallssignalgenerators 14 ist mit einem Eingang des Impulslichtsenders 13 verbunden, dem damit ein erstes Signal zugeführt wird, das zur Bestimmung der Pulslage der vom Impulslichtsender 13 abgegebenen Sende-Lichtimpulse dient.

Ein zweiter Ausgang des Zufallssignalgenerators 14 ist mit einem Eingang der Empfangssignalauswerteeinrichtung 16 verbunden, der damit ein zweites Ausgangssignal des Zufallssignalgenerators 14 zugeführt wird, das mit dem ersten Ausgangssignal des Zufallssignalgenerators identisch ist oder diesem entspricht.

Anhand des vom Zufallssignalgenerator 14 gelieferten Ausgangssignals prüft eine Auswerteeinrichtung 16 die Gültigkeit der empfangenen Lichtimpulse. Dabei wird die in Figur 2 gezeigte Sendeimpulsfolge 43, die von jedem Sender ausgesendet wird, mit dem Ausgangssignals des Zufallssignalgenerators 14 impulslagenmoduliert. Diese Impulsfolge ist daher zufallsmoduliert. Diese Modulation erfolgt so, dass der Sender 13 statt mit einer festen Sendefrequenz F bzw. einer festen Periode T mit einer mittleren Sendefrequenz Fa bzw. mit einer mittleren Periode Ta und einer Pulsdauer Tp sendet.

Der Zufallssignalgenerator 14 wird vorzugsweise so ausgeführt, dass jede Periodizität seines Ausgangssignals ausgeschlossen oder jedenfalls höchst unwahrscheinlich ist, auch während seiner Startphase.

Gemäss dem Vorstehendem werden erfindungsgemäss die verschiedenen Impulslichtsender möglichst vollständig desynchronisiert, um die Wahrscheinlichkeit einer gegenseitige störende Beeinflussung zwischen verschiedenen, in einem gemeinsamen optischen Raum angeordneten Sender-Empfänger-Paaren soweit zu reduzieren, dass eine derartige Beeinflussung praktisch nicht stattfindet. In dieser Beziehung unterscheidet sich, dass erfindungsgemässe Vorgehen, deutlich von einem Vorgehen, der versuchen würde, dasselbe Ziel durch eine möglichst genaue Synchronisierung der verschiedenen Sender, aber mit einer kontrollierter Phasenverschiebung zwischen den von den einzelnen Sendern gesendeten Lichtimpulse.

Der Zufallsgenerator 14 ist sehr einfach aufgebaut und nutzt z.B. das natürliche, im wesentlichen weisse Rauschen. Fig. 4 zeigt als Beispiel die Schaltung eines Zufallssignalgenerators 14, der ein Rauschsignalgenerator ist, bei dem eine Zenerdiode 17, z.B. Zenerdiode BZX84C6V2, als Rauschquelle verwendet wird, und mit dem ein im wesentlichen weisses Rauschens erzeugbar ist. Dieser Rauschsignalgenerator enthält die Serienschaltung einer DC Spannungsquelle 18, die z.B. eine Spannung von 10 Volt liefert, eines Widerstands 19 von z.B. 470 Ohm und der Zenerdiode 17. Das am Arbeitswiderstand 19 der Zenerdiode 17 anstehende Rauschsignal wird in einem Verstärker 21 verstärkt und in einem Impulsformer 22 in ein Rechtecksignal umgewandelt.

In einer zweiten Ausführungsform eines erfindungsgemässen fotoelektrischen Näherungsschalters ist der Zufallssignalgenerator 14 als Pseudozufallssignalgenerator ausgebildet.

Als Pseudozufallssignalgenerator ist z.B. im Rahmen der vorliegenden Erfindung ein sogenannter "digital noise generator" als Impulsgeber 14 verwendbar, Ein solcher Pseudozufallssignalgenerator umfasst z.B. ein Schieberegister, das mit Exklusiv-Oder-Gattern rückgekoppelt ist.

Ein Pseudozufallssignalgenerator ist allerdings als Zufallssignalgenerator weniger geeignet als ein Rauschsignalgenerator, da sein Ausgangssignal immer eine gewisse Periodizität aufweist.

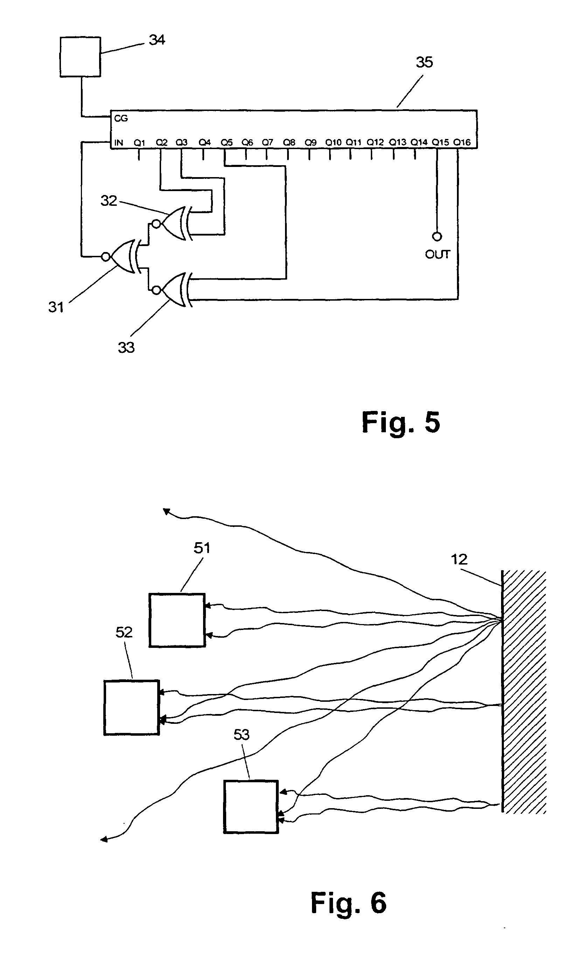

Fig. 5 zeigt eine typische Ausführung eines Pseudozufallssignalgenerators, bei dem Exklusiv-Oder-Gatter 31, 32, 33 mit den Parallelausgängen Q2, Q3, Q5 und Q16 eines mit einem Taktgenerator 34 an seinem Eingang IN getakteten Schieberegisters 35 verbunden sind, so dass an dessen Ausgang OUT die Polynomialfunktion

$$f(x) = 1 + x^2 + x^3 + x^5 + x^{16}$$

seriell auslesbar ist. Diese Funktion gleicht einer Zufallsimpulsfolge. Sie ist allerdings nicht zufällig, sondern wiederholt sich mit einer Periode von $2^n$ (n = Anzahl Flip-Flops des Schieberegisters) Taktimpulsen des Taktgenerators 34.

Aus praktischen Gründen ist es von Vorteil , den Wertebereich des mittels des als Impulsgeber 14 verwendeten Zufallssignalgenerators oder Pseudozufallssignalgenerators erzeugten, variablen Intervall zwischen aufeinanderfolgenden Sendeimpulsen zu beschränken. Zu kurze Intervalle sind ungünstig, weil sie eine Überlastung der Sendediode und eine zu kurze Erholungszeit des Empfängers verursachen würden. Zu lange Intervalle sind auch nachteilig, weil sie Aussetzer in der Auswerteeinrichtung 16 verursachen würden. Der Zufallssignalgenerators oder Pseudozufallssignalgenerator 14 wird daher vorzugsweise so eingerichtet, dass die Länge der damit erzeugten zufällig verteilten Abstände zwischen aufeinanderfolgende Sende-Lichtimpulse Werte annimmt, die in einem vorbestimmten Bereich liegen, der durch einen minimalen und einen maximalen Grenzwert definiert ist.

Mit einer ersten Ausführungsform der Auswerteeinrichtung 16 wird den folgenden Fakten Rechnung getragen:

Auch bei Verwendung von zufallsmodulierten Signalen kommen beim Empfang Impulskollisionen vor. Die Häufigkeit solcher Kollisionen steigt zudem mit der Anzahl M von sich im selben Raum befindlichen Sendern an. Deshalb wird durch die in der Auswerteeinrichtung 16 durchgeführte, empfängerseitige Auswertung einer Folge von N Impulsen sichergestellt, dass die Gesamt-Kollisionswahrscheinlichkeit unter den für die jeweilige Anwendung benötigten Wert sinkt. Für die Auslösung eines Zustandswechsels des Ausgangssignals des Empfängers, welcher Zustandswechsel ein Gegenstands-Feststellungssignal ist, muss somit jeweils eine Anzahl N gültige Impulse in ununterbrochener Folge empfangen werden. Als gültig wird dabei jeder empfangene Impuls betrachtet, der im Wesentlichen die gleiche zeitliche Lage wie ein korrespondierender gesendeter Lichtimpuls hat, aber unabhängig davon, ob dieser wirklich von dem Sender ausgesandt wurde, der dem Empfänger 15 zugeordnet ist, was die Auswerteeinrichtung 16 nicht feststellen kann.

Zusätzliche Sendeimpulse, d.h. Sendeimpulse, die ausserhalb der Sendeimpulse des zum Empfänger eines Sender-Empfänger-Paares zugehörigen Senders liegen, werden nicht ausgewertet. Mit bekannten Verfahren der Wahrscheinlichkeitsrechnung und Statistik kann gezeigt werden, dass die Kollisionswahrscheinlichkeit $P_1$ durch die folgende Formel zu berechnen ist:

$$P_1 = \frac{C\binom{N-A}{A*(M-2)}}{C\binom{N}{A*(M-1)}}$$

C bedeutet: Kombination von ( ) mit

$$A = T_p * N * F_a$$

Bei gegebenem M, Tp und Fa kann N so gewählt werden, dass die gewünschte Kollisionswahrscheinlichkeit erreicht wird. Diese kann auf beliebig tiefe Werte (ausgenommen null) festgelegt werden. Allerdings wird bei Erhöhung von N die nutzbare Schaltfrequenz entsprechend reduziert. Es muss deshalb fallweise ein Kompromiss zwischen der Schaltfrequenz, M, Tp, Fa und N gewählt werden Beispielsweise ergeben sich mit M = 5, Tp = 1 Mikrosekunde, Fa = 15 kHz und N = 500 eine Kollisionswahrscheinlichkeit von $1{,}25*10^{-17}$ oder einem Ereignis in 1'270'000 Jahren und eine Schaltfrequenz von 1 kHz.

Mit einer bevorzugten Variante der Auswerteeinrichtung 16 wird dem Umstand Rechnung getragen, dass es in der Praxis vorkommen kann, dass nicht alle ausgesendeten Impulse erfolgreich empfangen werden, z.B. wegen elektrischer Störungen oder Rauschens der Eingangsstufe. Um dieser Möglichkeit Rechnung zu tragen, wird in einer Variante der Auswerteeinrichtung 16 , von der oben angegebenen Bedingung (ununterbrochene Folge von N Impulsen) abgewichen, indem man in der Impulsfolge N eine Anzahl K fehlende Impulse zulässt, die nach der oben erwähnte Bedingung vorhanden sein müssten. Zur Beibehaltung einer gegebenen Kollisionswahrscheinlichkeit muss allerdings bei Zulassung von K > 0 der ursprüngliche Wert von N auf einen höheren Wert $N_k$ erhöht werden.

Für die Auslösung eines Zustandswechsels des Ausgangssignals des Empfängers, welcher Zustandswechsel ein Gegenstands-Feststellungssignal ist, müssen bei dieser Variante der Auswerteeinrichtung 16 jeweils Nk Lichtimpulsen empfangen werden, und davon müssen von der Auswerteeinrichtung 16 Nk - K Impulse als gültig anerkannt werden, wobei jeder Impuls als gültig anerkannt wird, der im wesentlichen die gleiche zeitliche Lage wie ein korrespondierender gesendeter Lichtimpuls hat, wobei K = Nk - N und K eine positive ganze Zahl ist.

Für die soeben erwähnte Funktionsweise der Auswerteeinrichtung 16 kann gezeigt werden, dass die Kollisionswahrscheinlichkeit $P_2$ durch die folgende Formel zu berechnen ist:

$$P_2 = \frac{\sum_{i=0}^{A-K} C\binom{A}{i} * C\binom{N_K - A}{A*(M-2)+i}}{C\binom{N_K}{A}}$$

Bei den oben beschriebenen Verfahren muss eine Anzahl Impulse N bzw. $N_K$ abgewartet werden, bevor ein Wechsel des Ausgangssignals des Gerätes vorgenommen werden darf. Die nutzbare Schaltfrequenz des fotoelektrischen Näherungsschalters reduziert sich dementsprechend, so dass der resultierende Wert der Schaltfrequenz für gewisse Anwendungen zu tief sein kann. Allerdings wird, wie oben erwähnt, auch bereits bei den heute verwendeten einfachen Geräten in der Regel eine Anzahl $N_0$ gültige Impulse abgezählt, bevor ein Wechsel des Ausgangssignals des Gerätes vorgenommen wird. Die nutzbare Signalfrequenz wird also bereits bei den dem Stand der Technik entsprechenden Geräten reduziert.

In bevorzugten Ausführungsformen des erfindungsgemässen Näherungsschalters wird eine unerwünschte Reduktion der Schaltfrequenz durch folgende Massnahmen verkleinert:

1. Die Impulsdauer Tp der gesendeten Lichtimpulse wird bei gleichbleibender mittlerer Modulationsfrequenz Fa reduziert. Mit den zur Verfügung stehenden Bauteilen ist eine Reduktion der heute üblichen Werte für Tp von ca. 2 bis 10 Mikrosekunde auf 1 Mikrosekunde oder weniger problemlos möglich. Eine Reduktion der Impulsbreite auf die Hälfte reduziert den für N erforderlichen Wert auf weniger als die Hälfte (bei gleichbleibender Kollisionswahrscheinlichkeit).

2. Wird von der Auswerteeinrichtung 16 eine kurze Folge, z.B. Ns, gültige Impulse festgestellt und ist damit ein Wechsel des Zustands des Ausgangssignals der Auswerteeinrichtung 16 wahrscheinlich, so wird die Modulationsfrequenz Fa für die nächsten N-Ns bzw. $N_K$-Ns Impulse stark erhöht, z. B. verdoppelt (Burst). Die benötigte Zeit zum Erreichen von N bzw. $N_K$ wird dadurch entsprechend verkürzt, ohne Einfluss auf die Kollisionswahrscheinlichkeit.

3. Die Auswerteeinrichtung 16 wird zur permanenten Überwachung der von anderen als dem eigenen Sender kommenden Fremdimpulse eingesetzt. Bei keinen oder wenigen Fremdimpulsen kann N bzw. $N_K$ dynamisch reduziert werden, mit entsprechender Erhöhung der nutzbaren Schaltfrequenz.

Die vorliegende Erfindung betrifft somit ein Verfahren, das eine gegenüber dem Stand der Technik sehr stark reduzierte Beeinflussung zwischen benachbarten Geräten aufweist. Die Einsatzmöglichkeiten solcher Geräte werden damit wesentlich erweitert und deren Anwendung vereinfacht.

AUSFÜHRUNGSBEISPIEL EINES ERFINDUNGSGEMÄSSEN SYSTEMS

Fig. 6 zeigt schematisch ein System, das eine Vielzahl von erfindungsgemässen fotoelektrischen Näherungsschalter 51, 52, 53, etc., umfasst, und das z.B. zur Feststellung der Anwesenheit eines Gegenstandes 12 in einem Überwachungsbereich dient. Jeder der fotoelektrischen Näherungsschalter 51, 52, 53, etc., kann der Aufbau und die Funktionsweise von einer der oben beschriebenen Ausführungsformen haben.

AUSFÜHRUNGSBEISPIEL EINES ERFINDUNGSGEMÄSSEN VERFAHRENS

Zur Durchführung eines erfindungsgemässen Verfahrens zur Feststellung von einem in einem Überwachungsbereich vorhandenen Gegenstand 12 wird z.B. einer der oben beschriebenen Ausführungsformen eines fotoelektrischen Näherungsschalters verwendet. Dabei wird

(a) die Impulssequenz der vom Impulslichtsender (13) abgegebenen Sende-Lichtimpulse mittels eines ersten Ausgangssignals eines als Impulsgeber verwendeten Zufallssignalgenerators oder Pseudozufallssignalgenerators pulslagenmoduliert wird, und

(b) ein zweites Ausgangssignal des Zufallssignalgenerators, welches mit dem ersten Ausgangssignal des Zufallssignalgenerators oder Pseudozufallssignalgenerators identisch ist oder diesem entspricht, zur Steuerung der Funktion der Empfangssignalauswerteeinrichtung (16) verwendet wird.

In einer ersten Ausführungsform des soeben definierten Verfahrens werden die vom Lichtempfänger 15 empfangenen Lichtimpulse in einer Auswerteeinrichtung verarbeitet, die ein Gegenstands-Feststellungssignal abgibt, wenn der Lichtempfänger 15 eine ununterbrochene Folge von N Lichtimpulsen empfängt, jeder der N empfangenen Impulse im Wesentlichen die gleiche zeitliche Lage wie ein korrespondierender gesendeter Lichtimpuls hat.

In einer zweiten Ausführungsform des soeben definierten Verfahrens werden die vom Lichtempfänger 15 empfangenen Lichtimpulse in einer Auswerteeinrichtung verarbeitet, die ein Gegenstands-Feststellungssignal abgibt, wenn der Lichtempfänger 15 eine Folge von Nk Lichtimpulsen empfängt, wobei jeder von einer Anzahl Nk - K empfangenen Lichtimpulse im Wesentlichen die gleiche zeitliche Lage wie ein korrespondierender gesendeter Lichtimpuls hat, wobei K = Nk - N und K eine positive ganze Zahl ist.

Zur Erhöhung der Schaltfrequenz sieht das erfindungsgemässe Verfahren vor, folgende Massnahmen einzeln oder in Kombination anzuwenden:

- die Verwendung von Sende-Lichtimpulsen, die eine Impulsdauer (Tp) aufweisen, die kleiner als zwei Mikrosekunden ist,

- die mittlere Impulsfrequenz (Fa) der von Impulslichtsender 13 abgegebenen Sende-Lichtimpulse über ausgewählte Zeitintervalle zu erhöhen, wenn die Zahl der über einen Empfangsintervall empfangenen, von einer Auswerteeinrichtung als gültig erkannte Lichtimpulse kleiner als ein vorbestimmter Wert ist.

Im Rahmen der vorliegenden Erfindung kommen alle Lichtwellenlängen in Betracht, also sichtbares Licht, Infrarot- und Ultraviolettstrahlung.

Bezugszeichenliste

| 11 | Fotoelektrischer Näherungsschalter |
|----|-----|
| 12 | Gegenstand |
| 13 | Impulslichtsender |
| 14 | Impulsgeber / Zufallssignalgenerator/ Pseudozufallssignalgenerators / Rauschsignalgenerator |
| 15 | Lichtempfänger |
| 16 | Empfangssignalauswerteeinrichtung |
| 17 | Zenerdiode |
| 18 | DC Spannungsquelle |
| 19 | Widerstand |

| 21 | Verstärker |
|----|-----|
| 22 | Impulsformer |

| 31 | Exklusiv-Oder-Gatter |
|----|-----|
| 32 | Exklusiv-Oder-Gatter |
| 33 | Exklusiv-Oder-Gatter |
| 34 | Taktgenerator |
| 35 | Schieberegister |

| 41 | pulsmodulierte Sende-Lichtimpulse |
|----|-----|
| 42 | Ausgangssignal der Empfangseinrichtung |
| 43 | impulsmodulierte Folge von Sende-Lichtimpulse |
| 44 | Ausgangssignal der Auswerteeinrichtung |

| 51 | Sender-Empfänger-Paar |
|----|-----|
| 52 | Sender-Empfänger-Paar |
| 53 | Sender-Empfänger-Paar |

| F | Frequenz der gesendeten Lichtimpulse |
|----|-----|
| T | Periode der gesendeten Lichtimpulse |
| Fa | Durchschnittswert der Frequenz der gesendeten Lichtimpulse |
| Ta | Durchschnittswert der Periode der gesendeten Lichtimpulse |

Tp    Dauer eines gesendeten Lichtimpulses
M     Anzahl Impulslichtsender, die sich im selben Raum befinden
No    Anzahl empfangener Lichtimpulse (gemäss Stand der Technik)
N     Anzahl empfangener Lichtimpulse (im ersten Ausführungsbeispiel der Auswerteeinrichtung)
Nk    Anzahl empfangener Lichtimpulse (im zweiten Ausführungsbeispiel der Auswerteeinrichtung)
Ns    Anzahl empfangener Lichtimpulse (im dritten Ausführungsbeispiel der Auswerteeinrichtung)
K     positive ganze Zahl
P1    Kollisionswahrscheinlichkeit
P2    Kollisionswahrscheinlichkeit


**Patentansprüche**

1. Fotoelektrischer Näherungsschalter (11) zur Feststellung von einem in einem Überwachungsbereich vorhandenen Gegenstand (12), welcher fotoelektrische Näherungsschalter
einen Impulslichtsender (13) zum Aussenden von Sende-Lichtimpulsen in den Überwachungsbereich, die von einem Ausgangssignal eines Impulsgebers (14) ausgelöst sind und voneinander je einen zeitlichen Abstand aufweisen, und
einen Lichtempfänger (15) enthält, der relativ zum Impulslichtsender (13) und zum Überwachungsbereich so anordbar ist, dass er bei Abwesenheit von einem festzustellendem Gegenstand (12) im Überwachungsbereich im Wesentlichen kein Licht vom Impulslichtsender (13) empfängt, jedoch bei Anwesenheit eines festzustellenden Gegenstandes im Überwachungsbereich durch Reflexion so viel Licht vom Impulslichtsender (13) erhält, dass eine an den Lichtempfänger (15) angeschlossene Empfangssignalauswerteeinrichtung (16) ein Gegenstands-Feststellungssignal abgibt, wobei
der Impulsgeber (14) ein Zufallssignalgenerator oder ein Pseudozufallssignalgenerator ist,
ein Ausgang des Impulsgebers mit einem Eingang des Impulslichtsenders verbunden ist, dem damit ein erstes Ausgangssignal des Impulsgebers zuführbar ist, das mittels des Zufallssignalgenerators oder des Pseudozufallssignalgenerators erzeugt wird und zur Bestimmung der Pulslage der vom Impulslichtsender (13) abgegebenen Sende-Lichtimpulse dient, und
ein Ausgang des Impulsgebers mit einem Eingang der Empfangssignalauswerteeinrichtung (16) verbunden ist, der damit ein zweites Ausgangssignal des Impulsgebers zuführbar ist, das mit dem ersten Ausgangssignal des Zufallssignalgenerators oder des Pseudozufallssignalgenerators identisch ist oder diesem entspricht, **dadurch gekennzeichnet, dass**
die Empfangssignalauswerteeinrichtung (16) eine Auswerteeinrichtung enthält, die ein Gegenstands-Feststellungssignal abgibt, wenn der Lichtempfänger (15) aus einer Folge von Ni Sende-Lichtimpulsen (43) mindestens Ni-K Lichtimpulse empfängt, von denen jeder im Wesentlichen die gleiche zeitliche Lage wie ein korrespondierender Sende-Lichtimpuls hat, wobei Ni und K positive ganze Zahlen sind und die K Sende-Lichtimpulse, die der Lichtempfänger (15) aus der Folge von Ni Sende-Lichtimpulsen (43) nicht empfängt, beliebige Sende-Lichtimpulse aus der Folge von Ni Sende-Lichtimpulsen (43) sind.

2. Fotoelektrischer Näherungsschalter gemäss Anspruch 1, **dadurch gekennzeichnet, dass** der Zufallssignalgenerator ein Rauschsignalgenerator ist.

3. Fotoelektrischer Näherungsschalter gemäss Anspruch 2, **dadurch gekennzeichnet, dass** mit dem Rauschsignalgenerator ein im Wesentlichen weisses Rauschens erzeugbar ist.

4. Fotoelektrischer Näherungsschalter gemäss Anspruch 1, **dadurch gekennzeichnet, dass** der Zufallssignalgenerator oder der Pseudozufallssignalgenerator so eingerichtet ist, dass die Länge der damit erzeugten zufällig verteilten Abstände zwischen aufeinanderfolgende Sende-Lichtimpulse Werte annimmt, die in einem vorbestimmten Bereich liegen, der durch einen minimalen und einen maximalen Grenzwert definiert ist.

5. Fotoelektrischer Näherungsschalter gemäss Anspruch 1, **dadurch gekennzeichnet, dass** der Impulslichtsender (13) so eingerichtet ist, dass jeder der von ihm abgegebenen Sende-Lichtimpulse eine Impulsdauer (Tp) aufweist, die kleiner als zwei Mikrosekunden ist.

6. Fotoelektrischer Näherungsschalter gemäss Anspruch 1, **dadurch gekennzeichnet, dass** der Impulslichtsender (13) so eingerichtet ist, dass die mittlere Impulsfrequenz (Fa) der von ihm abgegebenen Sende-Lichtimpulse über ausgewählte Zeitintervalle erhöht werden kann.

7. Fotoelektrischer Näherungsschalter gemäss Anspruch 1, **dadurch gekennzeichnet, dass** er ferner Mittel zur Erfassung und Auswertung von Störimpulsen enthält.

8. Fotoelektrischer Näherungsschalter gemäss Anspruch 1, **dadurch gekennzeichnet, dass** die Auswerteeinrichtung (16) dazu eingerichtet ist, die von anderen als dem eigenen Sender kommenden Fremdimpulse permanent zu überwachen, und die Zahl der Impulse dynamisch zu reduzieren, die empfangen werden müssen, um das Gegenstands-Feststellungssignal abzugeben, wenn die Zahl der Fremdimpulse unter einen Mindestwert fällt.

9. System zur Feststellung von in einem Überwachungsbereich vorhandenen Gegenständen, **dadurch gekennzeichnet dass**, es eine Vielzahl von fotoelektrischen Näherungsschaltern (51, 52, 53) enthält, wobei alle oder ein Teil dieser fotoelektrischen Näherungsschalter gemäss einem der Ansprüche 1-8 ausgebildet ist.

10. Verfahren zur Feststellung von einem in einem Überwachungsbereich vorhandenen Gegenstand (12) mittels eines fotoelektrischer Näherungsschalters, welcher
einen Impulslichtsender (13), der von einem Ausgangssignal eines Impulsgebers (14) ausgelöste, voneinander je einen zeitlichen Abstand aufweisende Sende-Lichtimpulse in den Überwachungsbereich aussendet, und
einen Lichtempfänger (15) enthält, der relativ zum Impulslichtsender (13) und zum Überwachungsbereich so angeordnet ist, dass er bei Abwesenheit von einem festzustellendem Gegenstand (12) im Überwachungsbereich im Wesentlichen kein Licht vom Impulslichtsender (13) empfängt, jedoch bei Anwesenheit eines festzustellendem Gegenstand (12) im Überwachungsbereich durch Reflexion so viel Licht vom Impulslichtsender (13) erhält, dass eine an den Lichtempfänger (15) angeschlossene Empfangssignalauswerteeinrichtung (16) ein Gegenstands-Feststellungssignal abgibt, wobei
die Impulssequenz der vom Impulslichtsender (13) abgegebenen Sende-Lichtimpulse mittels eines ersten Ausgangssignals eines Zufallssignalgenerators oder eines Pseudozufallssignalgenerators pulslagenmoduliert wird, und wobei ein zweites Ausgangssignal des Impulsgebers, welches mit dem ersten Ausgangssignal des Zufallssignalgenerators oder des Pseudozufallssignalgenerators identisch ist oder diesem entspricht, zur Steuerung der Funktion der Empfangssignalauswerteeinrichtung (16) verwendet wird, **dadurch gekennzeichnet ist, dass**
die vom Lichtempfänger (15) empfangenen Lichtimpulse in einer Auswerteeinrichtung derart verarbeitet werden, dass sie ein Gegenstands-Feststellungssignal abgibt, wenn der Lichtempfänger (15) aus einer Folge von Ni Sende-Lichtimpulsen (43) mindestens Ni-K Lichtimpulse empfängt, von denen jeder im Wesentlichen die gleiche zeitliche Lage wie ein korrespondierender Sende-Lichtimpuls hat, wobei Ni und K positive ganze Zahlen sind und die K Sende-Lichtimpulse, die der Lichtempfänger (15) aus der Folge von Ni Sende-Lichtimpulsen (43) nicht empfängt, beliebige Sende-Lichtimpulse aus der Folge von Ni Sende-Lichtimpulsen (43) sind.

11. Verfahren gemäss Anspruch 10, **dadurch gekennzeichnet, dass** jedes der Sende-Lichtimpulse eine Impulsdauer (Tp) aufweist, die kleiner als zwei Mikrosekunden ist.

12. Verfahren gemäss Anspruch 10, **dadurch gekennzeichnet, dass** die mittlere Impulsfrequenz (Fa) der von Impulslichtsender (13) abgegebenen Sende-Lichtimpulse über ausgewählte Zeitintervalle erhöht wird, wenn die Zahl der über einen Empfangsintervall empfangenen, von einer Auswerteeinrichtung als gültig erkannte Lichtimpulse kleiner als ein vorbestimmter Wert ist.

13. Verfahren gemäss Anspruch 12, **dadurch gekennzeichnet, dass** die Auswerteeinrichtung (16) die von anderen als dem eigenen Sender kommenden Fremdimpulse permanent überwacht, und die Zahl der Impulse dynamisch reduziert, die empfangen werden müssen, um das Gegenstands-Feststellungssignal abzugeben, wenn die Zahl der Fremdimpulse unter einen Mindestwert fällt.

**Claims**

1. Photoelectric proximity switch (11) for detecting an object (12) present in a monitored area, the photoelectric proximity switch comprising
a light pulse transmitter (13) for emitting transmitting light pulses into the monitored area that are triggered by an output signal of a pulse generator (14) and have a time interval between each of them, and
a light receiver (15) that is apt to be arranged in relation to the light pulse transmitter (13) and to the monitored area in such a manner that in the absence of an object (12) to be detected in the monitored area, it receives essentially no light from the light pulse transmitter (13), but in the presence of an object to be detected in the monitored area, it receives such an amount of light from the light pulse transmitter (13) due to reflection that a receiving signal evaluating device (16) connected to the light receiver (15) delivers an object detection signal,

the pulse generator (14) being a random signal generator or a pseudo-random signal generator,

an output of the pulse generator being connected to an input of the light pulse transmitter, which is thus apt to be supplied with a first output signal of the pulse generator that is generated by the random signal generator or the pseudo-random signal generator and serves for determining the pulse position of the transmitting light pulses emitted by the light pulse transmitter (13), and

an output of the pulse generator being connected to an input of the receiving signal evaluating device (16), which is thus apt to be supplied with a second output signal of the pulse generator that is identical or corresponds to the first output signal of the random signal generator or of the pseudo-random signal generator, **characterised in that** the receiving signal evaluating device (16) comprises an evaluating unit that delivers an object detection signal when the light receiver (15) receives from a sequence of Ni transmitting light pulses (43) at least Ni-K light pulses having each substantially the same temporal position as a corresponding transmitting light pulse, Ni and K being positive integers, and the K transmitting light pulses that the light receiver (15) does not receive from the sequence of Ni transmitting light pulses (43) being any of the transmitting light pulses in the sequence of Ni transmitting light pulses (43).

2. Photoelectric proximity switch according to claim 1, **characterised in that** the random signal generator is a noise signal generator.

3. Photoelectric proximity switch according to claim 2, **characterised in that** the noise signal generator is apt to generate essentially white noise.

4. Photoelectric proximity switch according to claim 1, **characterised in that** the random signal generator or the pseudo-random signal generator is so designed that the length of the randomly distributed intervals between successive transmitting light pulses generated therein takes values that are comprised in a predetermined range defined by a minimum and maximum limit.

5. Photoelectric proximity switch according to claim 1, **characterised in that** the light pulse transmitter (13) is so designed that each of the emitted transmitting light pulses has a pulse duration (Tp) of less than two microseconds.

6. Photoelectric proximity switch according to claim 1, **characterised in that** the light pulse transmitter (13) is so designed that the mean pulse frequency (Fa) of the emitted transmitting light pulses can be increased over selected time intervals.

7. Photoelectric proximity switch according to claim 1, **characterised in that** it further comprises means for detecting and evaluating stray pulses.

8. Photoelectric proximity switch according to claim 1, **characterised in that** the evaluating device (16) is designed for the permanent surveillance of stray pulses emitted by other transmitters than its own and for dynamically reducing the number of pulses that have to be received in order to deliver the object detection signal when the number of stray pulses falls below a minimum value.

9. System for detecting of objects present in a monitored area, **characterised in that** it comprises a plurality of photoelectric proximity switches (51, 52, 53), all or a part of these photoelectric proximity switches being designed according to any one of claims 1 to 8.

10. Method for detecting an object (12) present in a monitored area by means of a photoelectric proximity switch comprising

a light pulse transmitter (13) that emits transmitting light pulses into the monitored area that are triggered by an output signal of a pulse generator (14) and have a time interval between each of them, and

a light receiver (15) arranged in relation to the light pulse transmitter (13) and to the monitored area in such a manner that in the absence of an object (12) to be detected in the monitored area, it receives essentially no light from the light pulse transmitter (13), but in the presence of an object (12) to be detected in the monitored area, it receives such an amount of light from the light pulse transmitter (13) due to reflection that a receiving signal evaluating device (16) connected to the light receiver (15) delivers an object detection signal,

the pulse sequence of the transmitting light pulses emitted by the light pulse transmitter (13) being pulse-position modulated by means of a first output signal of a random signal generator or a pseudo-random signal generator, and a second output signal of the pulse generator that is identical or corresponds to the first output signal of the random signal generator or of the pseudo-random signal generator being used for the control of the operation of the receiving signal evaluating device (16),

**characterised in that**

the light pulses received by the light receiver (15) are processed in an evaluating device such that it delivers an object detection signal when the light receiver (15) receives from a sequence of Ni transmitting light pulses (43) at least Ni-K light pulses having each substantially the same temporal position as a corresponding transmitting light pulse, Ni and K being positive integers, and the K transmitting light pulses that the light receiver (15) does not receive from the sequence of Ni transmitting light pulses (43) being any of the transmitting light pulses in the sequence of Ni transmitting light pulses (43).

11. Method according to claim 10, **characterised in that** each one of the transmitting light pulses has a pulse duration (Tp) of less than two microseconds.

12. Method according to claim 10, **characterised in that** the mean pulse frequency (Fa) of the transmitting light pulses emitted by the light pulse transmitter (13) is increased over selected time intervals if the number of light pulses received in a receiving interval and accepted as valid by an evaluating device is smaller than a predetermined value.

13. Method according to claim 10, **characterised in that** the evaluating device (16) permanently monitors the stray pulses emitted by other transmitters than its own and dynamically reduces the number of pulses that have to be received in order to deliver the object detection signal when the number of stray pulses falls below a minimum value.

**Revendications**

1. Détecteur de proximité photoélectrique (11) pour détecter un objet (12) présent dans un domaine de surveillance, lequel détecteur de proximité photoélectrique comporte

un émetteur d'impulsions lumineuses (13) pour émettre dans le domaine de surveillance des impulsions lumineuses d'émission déclenchées par un signal de sortie d'un générateur d'impulsions (14) et présentant un intervalle de temps l'une par rapport à l'autre, et

un récepteur de lumière (15) pouvant être disposé par rapport à l'émetteur d'impulsions lumineuses (13) et au domaine de surveillance de manière qu'en absence d'un objet (12) à détecter dans le domaine de surveillance, il ne reçoive pas pour l'essentiel de lumière de l'émetteur d'impulsions lumineuses (13), mais qu'en présence d'un objet à détecter dans le domaine de surveillance, il reçoive de l'émetteur d'impulsions lumineuses (13) par réflexion assez de lumière pour qu'un dispositif d'analyse des signaux de réception (16) connecté au récepteur de lumière (15) délivre un signal de détection d'objet,

le générateur d'impulsions (14) étant un générateur de signaux aléatoires ou un générateur de signaux pseudoaléatoires,

une sortie du générateur d'impulsions étant reliée à une entrée de l'émetteur d'impulsions lumineuses auquel peut ainsi être amené un premier signal de sortie du générateur d'impulsions, qui est généré au moyen du générateur de signaux aléatoires ou du générateur de signaux pseudoaléatoires et sert à déterminer la position des impulsions lumineuses d'émission émises par l'émetteur d'impulsions lumineuses (13), et

une sortie du générateur d'impulsions étant reliée à une entrée du dispositif d'analyse des signaux de réception (16), auquel peut ainsi être amené un deuxième signal de sortie du générateur d'impulsions, qui est identique au premier signal de sortie du générateur de signaux aléatoires ou du générateur de signaux pseudoaléatoires ou correspond à celui-ci, **caractérisé en ce que**

le dispositif d'analyse des signaux de réception (16) comporte un dispositif d'analyse qui transmet un signal de détection d'objet lorsque le récepteur de lumière (15) reçoit parmi une série de Ni impulsions lumineuses d'émission (43) au moins Ni-K impulsions lumineuses dont chacune a pour l'essentiel la même position temporelle qu'une impulsion lumineuse d'émission correspondante, Ni et K étant des nombres entiers positifs, et les K impulsions lumineuses d'émission que le récepteur de lumière (15) ne reçoit pas parmi la série de Ni impulsions lumineuses d'émission (43) étant des impulsions lumineuses d'émission quelconques parmi la série de Ni impulsions lumineuses d'émission (43).

2. Détecteur de proximité photoélectrique selon la revendication 1, **caractérisé en ce que** le générateur de signaux aléatoires est un générateur de signaux de bruit.

3. Détecteur de proximité photoélectrique selon la revendication 2, **caractérisé en ce qu'**un bruit pour l'essentiel blanc peut être généré avec le générateur de signaux de bruit.

**4.** Détecteur de proximité photoélectrique selon la revendication 1, **caractérisé en ce que** le générateur de signaux aléatoires ou le générateur de signaux pseudoaléatoires est ajusté de manière que la longueur des écarts, ainsi générés avec distribution aléatoire, entre des impulsions lumineuses d'émission successives prenne des valeurs qui sont comprises dans une plage prédéterminée qui est définie par une valeur limite minimale et une valeur limite maximale.

**5.** Détecteur de proximité photoélectrique selon la revendication 1, **caractérisé en ce que** l'émetteur d'impulsions lumineuses (13) est conçu de manière que chacune des impulsions lumineuses d'émission qu'il émet présente une durée d'impulsion (Tp) qui est inférieure à deux microsecondes.

**6.** Détecteur de proximité photoélectrique selon la revendication 1, **caractérisé en ce que** l'émetteur d'impulsions lumineuses (13) est conçu de manière que la fréquence moyenne d'impulsion (Fa) des impulsions lumineuses d'émission qu'il émet peut être augmentée pendant des intervalles de temps choisis.

**7.** Détecteur de proximité photoélectrique selon la revendication 1, **caractérisé en ce qu'**il comporte en outre des moyens pour détecter et analyser des impulsions parasites.

**8.** Détecteur de proximité photoélectrique selon la revendication 1, **caractérisé en ce que** le dispositif d'analyse (16) est conçu afin de surveiller en permanence les impulsions parasites provenant d'autres émetteurs que le sien et afin de réduire de manière dynamique le nombre des impulsions qui doivent être reçues pour fournir le signal de détection d'objet lorsque le nombre des impulsions parasites tombe en dessous d'une valeur minimale.

**9.** Système pour détecter des objets présents dans un domaine de surveillance, **caractérisé en ce qu'**il comporte une pluralité de détecteurs de proximité photoélectriques (51, 52, 53), tous ces détecteurs de proximité photoélectriques ou une partie d'entre eux étant formés conformément à l'une des revendications 1 à 8.

**10.** Procédé pour détecter un objet (12) présent dans un domaine de surveillance au moyen d'un détecteur de proximité photoélectrique qui comporte
un émetteur d'impulsions lumineuses (13) qui émet dans le domaine de surveillance des impulsions lumineuses d'émission déclenchées par un signal de sortie d'un générateur d'impulsions (14) et présentant un intervalle de temps l'une par rapport à l'autre, et
un récepteur de lumière (15) qui est disposé par rapport à l'émetteur d'impulsions lumineuses (13) et au domaine de surveillance de manière qu'en absence d'un objet (12) à détecter dans le domaine de surveillance, il ne reçoive pas pour l'essentiel de lumière de l'émetteur d'impulsions lumineuses (13), mais qu'en présence d'un objet (12) à détecter dans le domaine de surveillance, il reçoive de l'émetteur d'impulsions lumineuses (13) par réflexion assez de lumière afin qu'un dispositif d'analyse des signaux de réception (16) connecté au récepteur de lumière (15) délivre un signal de détection d'objet,
la séquence des impulsions lumineuses d'émission fournies par l'émetteur d'impulsions lumineuses (13) au moyen d'un premier signal de sortie d'un générateur de signaux aléatoires ou d'un générateur de signaux pseudoaléatoires étant modulé par position d'impulsions, et
un deuxième signal de sortie du générateur d'impulsions, qui est identique au premier signal de sortie du générateur de signaux aléatoires ou du générateur de signaux pseudoaléatoires ou correspond à celui-ci, étant employé pour commander la fonction du dispositif d'analyse des signaux de réception (16),
**caractérisé en ce que**
les impulsions lumineuses reçues par le récepteur de lumière (15) sont traitées dans un dispositif d'analyse de telle manière qu'il transmet un signal de détection d'objet lorsque le récepteur de lumière (15) reçoit parmi une série de Ni impulsions lumineuses d'émission (43) au moins Ni-K impulsions lumineuses dont chacune a pour l'essentiel la même position temporelle qu'une impulsion lumineuse d'émission correspondante, Ni et K étant des nombres entiers positifs, et les K impulsions lumineuses d'émission que le récepteur de lumière (15) ne reçoit pas parmi la série de Ni impulsions lumineuses d'émission (43) étant des impulsions lumineuses d'émission quelconques parmi la série de Ni impulsions lumineuses d'émission (43).

**11.** Procédé selon la revendication 10, **caractérisé en ce que** chacune des impulsions lumineuses d'émission présente une durée d'impulsion (Tp) qui est inférieure à deux microsecondes.

**12.** Procédé selon la revendication 10, **caractérisé en ce que** la fréquence moyenne (Fa) des impulsions lumineuses d'émission générées par l'émetteur d'impulsions lumineuses (13) est augmentée pendant des intervalles de temps choisis lorsque le nombre des impulsions lumineuses reçues pendant un intervalle de réception et reconnues valables par un dispositif d'analyse est inférieur à une valeur prédéterminée.

13. Procédé selon la revendication 10, **caractérisé en ce que** le dispositif d'analyse (16) surveille en permanence les impulsions parasites provenant d'autres émetteurs que le sien et réduit de manière dynamique le nombre des impulsions qui doivent être reçues pour fournir le signal de détection d'objet lorsque le nombre des impulsions parasites tombe en dessous d'une valeur minimale.

41

$N_0$

$T_P$

$T$

42

## Fig. 1

43

$N$

Tp

Ta

44

## Fig. 2

**Fig. 3**

**Fig. 4**

**Fig. 5**

**Fig. 6**

EP 1 318 606 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4031142 C
- DE 19926214 A1

- US 5243182 A